Europäisches Patentamt

European Patent Office

Office européen des brevets

(19)

(11) Publication number: **0 068 843**
**B1**

# EUROPEAN PATENT SPECIFICATION

(12)

(45) Date of publication of patent specification: 20.04.88

(51) Int. Cl.⁴: **H 01 L 21/285, H 01 L 21/90**

(21) Application number: **82303326.1**

(22) Date of filing: **25.06.82**

(54) Method of producing a conductor in a desired pattern on a semiconductor substrate.

(30) Priority: **30.06.81 JP 102858/81**

(43) Date of publication of application:
**05.01.83 Bulletin 83/01**

(45) Publication of the grant of the patent:
**20.04.88 Bulletin 88/16**

(84) Designated Contracting States:
**DE FR GB**

(56) References cited:
**US-A-3 594 225**
**US-A-4 062 720**
**US-A-4 228 212**
**JOURNAL OF APPLIED PHYSICS, vol. 51, no.**
**12, December 1980, pages 6424-6425,**
**American Institute of Physics, New York, US**
**B.G. YACOBI et al.: "Compound formation**
**between amorphous silicon and chromium"**
**THIN SOLID FILMS, vol. 44, 1977, pages**
**149-153, Elsevier Sequoia S.A., Lausanne,**
**printend in the Netherlands Z.L. LIAU et al.:**
**"Repetitive growth stages in the solid phase**
**epitaxy of silicon"**

(73) Proprietor: **FUJITSU LIMITED**
**1015, Kamikodanaka Nakahara-ku**
**Kawasaki-shi Kanagawa 211 (JP)**

(72) Inventor: **Sato, Noriaki**
**4-28-21, Tsurakawa Machida-shi**
**Tokyo 194-01 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
**JOURNAL OF APPLIED PHYSICS, vol. 48, no. 7,**
**July 1977, pages 2886-2890, American Institute**
**of Physics, New York, US r.pretoorius et**
**al.:"Growth mechanisme for solid-phase**
**epitaxy of Si in the**

**Si(100)/Pd2Si/Si(amorphous) system studied**
**by a radioactive tracer technique"**

Courier Press, Leamington Spa, England.

## Description

The present invention relates to a method of producing a semidconductor device, more particularly to an improved method of producing gate electrodes and interconnection lines of metal oxide semiconductor (MOS) type transistors.

Electrodes and interconnection lines of conventional semiconductor devices, in particular, gate electrodes and interconnection lines of MOS type transistors, have often been made of polycrystalline silicon material. Polycrystalline silicon had been so chosen because of its self-alignment and numerous other convenient processing aspects. Polycrystalline silicon, however has the disadvantage in that its about $10^{-3}$ $\Omega \cdot cm$ electrical resistivity is not low enough and the signal delay of the resultant interconnection lines is too great in the light of the increasing miniaturization of semiconductor elements and the increasingly large scale of chips.

To solve these problems of resistivity and signal delay, techniques have been developed for the formation of electrodes and interconnection lines using one of the high melting point metals including molybdenum, titanium, niobium, tantalum, tungsten, vanadium, hafnium, zirconium, chromium, or one of the noble metals including, palladium and platinum, or nickel.

These metals are advantageous in that they have low electrical resistivity, for example, $10^{-6}$ to $10^{-5}$ $\Omega \cdot cm$, and can be finely worked. On the other hand, these metals have low resistance to reagents in particular, acids, therefore these metals are partially etched during the formation of contact holes for gate or source and drain electrodes.

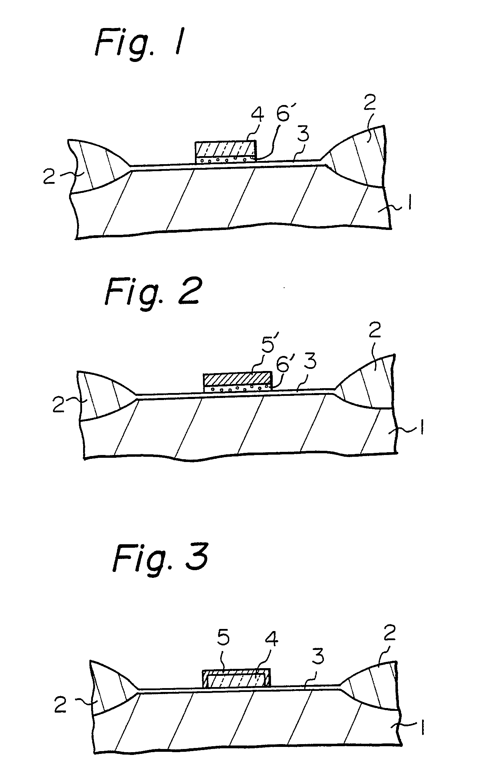

To counter this problem, various techniques have been proposed. For example, the gate electrode structure formed by molybdenum 4 and polycrystalline silicon 6' shown in Fig. 1 and the gate electrode structure formed of silicide layer 5' and polycrystalline silicon layer 6' shown in Fig. 2 are well known. However, the former has bad resistance against acids and the latter has high electrical resistivity.

The structure of the gate electrode formed by only silicide is also well known. The silicide gate has good resistance to acids, but does not have as low an electrical resistivity as metal gates.

Referring to Fig. 3, US—A—4228212 and US—A—4263058 teach a gate electrode formed by molybdenum 4 covered by molybdenum silicide 5. The gate electrode shown in Fig. 3 has resistance to acids and an electrical resistivity as low as a gate electrode formed by only metal. However, as described in the U.S. patents, the silicide 5 is formed by the process of forming an insulating layer such as silicon dioxide; then forming the conductor of a refractory metal in a desired pattern overlying the substrate 1; forming a layer of polycrystalline silicon over the layer of the silicon dioxide including the conductor of metallic material; patterning the layer of the polycrystalline layer to provide a patterned portion of the layer of polycrystalline silicon overlying the conductor and the substrate; including the conductor of metallic material, and heating the patterned portion of the layer of polycrystalline silicon to a temperature causing the patterned portion of the layer of polycrystalline silicon to react with a portion of the refractory metallic material. According to US—A—4228212 unreacted silicon and for part of the silicide layer is then oxidised to form an overlying layer of silicon dioxide.

In the above-mentioned process, the polycrystalline silicon is used as a material which reacts with metal to make silicide. However, when the polycrystalline silicon is heated, the grain size of the polycrystalline silicon is enlarged, thus the surface of the polycrystalline silicon is rough and the silicide is not uniform in thickness. In addition, in the reaction of the polycrystalline silicon with the refractory metallic material, the silicide is formed more in the polycrystalline silicon than in the refractory material. The formation of the silicide in the polycrystalline silicon layer is not uniform in thickness. The unevenness of the surface of the silicide makes it difficult to product fine patterning of gates. Furthermore, when the grain size of the polycrystalline silicon is enlarged, oxygen is introduced through the gaps in the grain to the metallic layer under the polycrystalline silicon. This may cause sublimation of parts of the metal.

In Figures 1 to 3, 1 is a semiconductor substrate and 2 and 3 are oxide layers.

According to the present invention, there is provided a method of producing a semiconductor device comprising the steps of providing a substrate of a semiconductor material; forming a conductor of a transition metal in a desired pattern on said substrate; forming a layer of amorphous silicon on said conductor and heating said substrate and said layer of amorphous silicon to a temperature enough to react said patterned portion of said layer of amorphous silicon with said conductor, thereby an overlying layer of silicide of said transition metal is formed.

Embodiments of the present invention provide methods of producing a composite conductive structure in a semiconductor device.

An embodiment of the present invention can provide a composite conductive structure, for use in a semiconductor device, which has low electrical resistivity.

An embodiment of the present invention can provide a composite conductive structure including an element resistant to reagents, particularly acids.

Reference is made, by way of example, to the accompanying drawings, in which:

Figures 1 to 3 are schematic cross-sectional views of a conventional composite conductor structure;

Figs. 4A to 4F (including Fig. 4d) are schematic cross-sectional views representing steps in the production of a semiconductor device in accordance with the present invention;

Fig. 5 is a schematic cross-sectional view of a substrate of a part of the region of a random access memory (RAM) produced by carrying out the present invention; and

Fig. 6 is a graph showing the calculated value of electrical resistivity of molybdenum covered by molybdenum silicide.

Below, a method of producing a semiconductor device embodying the present invention will be described in reference to Figs. 4A to 4F.

Referring to Fig. 4A, first a semiconductor substrate of silicon 1 is provided. Double layers of silicon dioxide film (not shown) and silicon nitride film (not shown) are selectively formed on the element formation region of the surface. The surface of the substrate of silicon 1 is then thermally oxidized using the double layers as a masking material. A field insulating layer of silicon dioxide 2 having a thickness of 500 nm to 1 μm is formed on the element separation region, then the masking material is removed. Next, the substrate of silicon is thermally oxidized to form a gate insulating layer of silicon dioxide 3 of 20 to 50 nm thickness on the element formation region.

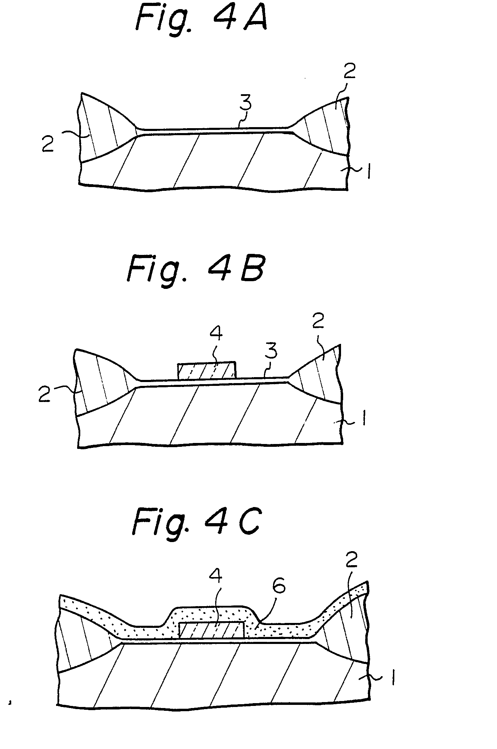

Referring to Fig. 4B, a layer of molybdenum 4 is overlaid on the entire surface of the insulating layer of silicon dioxide 3 to a suitable thickness, for example, 250 to 350 nm. Sputter deposition, vacuum vapor deposition, chemical vapor deposition, or other desired processes are carried out. The layer is then patterned by photoresist masking and etching techniques, well known in the photolithography art, to form a patterned gate electrode of molybdenum 4 having a suitable width, for example 1 to 2 μm. The etching may be carried out by plasma etching or reactive ion etching using a mixture of tetrafluorocarbon ($CF_4$) and oxygen ($O_2$) as the reactant.

Referring to Fig. 4C, an amorphous silicon layer 6 of about 50 or 100 to 200 nm thickness is formed over the entire substrate by sputter deposition. As a pretreatment prior to the sputter deposition, inverse sputter may be performed over the entire surface of the substrate. In an inverse sputtering, an bias voltage is unusually and inversely applied between an anode and a cathode, a surface of specimen is tapped with a molecule of gas (impacted by gas molecules) and an etching process is carried out. This pretreatment has the effect of removing any impurities and oxide films remaining on the surface of the molybdenum and exposing a clean surface, thereby facilitating the subsequent silicification reaction.

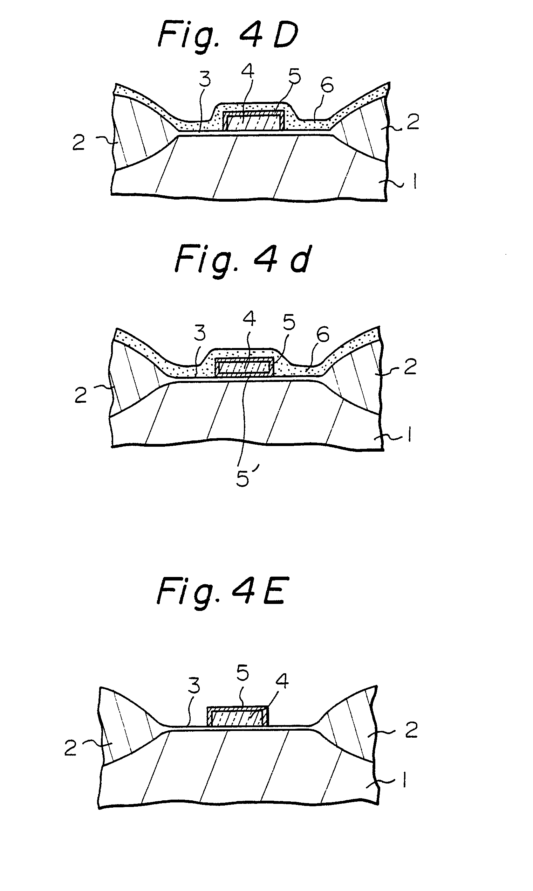

Referring to Fig. 4D, after the layer of amorphous silicon 6 is laid down, it is heat treated at a temperature of 600°C to 1000°C for 30 to 100 minutes in an atmosphere of dried nitrogen, argon, forming gas (inert gas including 5% of hydrogen), or the like so that the entire surface of the patterned gate electrode of molybdenum 4, except the bottom surface, reacts with the overlaying layer of amorphous silicon 4 to change to silicide 5.

Referring to Fig. 4d, since the adhesion of transition metals with silicon dioxide is not always good, it is advantageous to form the silicide between the patterned gate electrode composed of transition metal and the gate insulating layer composed of silicon dioxide 3. For this purpose, an amorphous silicon layer (not shown) is formed beforehand on the substrate of silicon 1 to a thickness of 40 to 60 nm; the above-mentioned layer of molybdenum 4 is formed on the layer of amorphous silicon then, after the patterning of the layer of molybdenum 4 to form the patterned gate electrode of molybdenum, another amorphous silicon layer is formed over the entire surface of the substrate as shown in Fig. 4C, silicification is carried out, as explained in Fig. 4D, whereby the bottom of the gate electrode patterned of molybdenum 4 is also covered with molybdenum silicide 5′, which has good adhesion with he insulating layer of silicon dioxide 2. The amorphous silicon layer not in the region of the gate electrode 4 is removed during the patterning process.

Referring to Fig. 4E, the entire surface of the substrate is etched by the plasma etching process, using tetrafluorocarbon gas as the reactant. In the plasma etching process of polycrystalline silicon, tetrafluorocarbon ($CF_4$) gas containing 5% of oxygen is used. However, when only fluorosilicate gas containing no oxygen is used, only polycrystalline silicon can be etched but molybdenum silicon can not be etched. Thus, the selective etching can be carried out. For example, when the plasma etching process is carried out at $CF_4$ gas flow rate of 250 cc/min and at a frequency of 13.56 MHz, the selective etching ratio of polycrystalline silicon to molybdenum silicide is given by four. The selective etching ratio can be improved by changing the gas, degree of vacuum, electric power and the like.

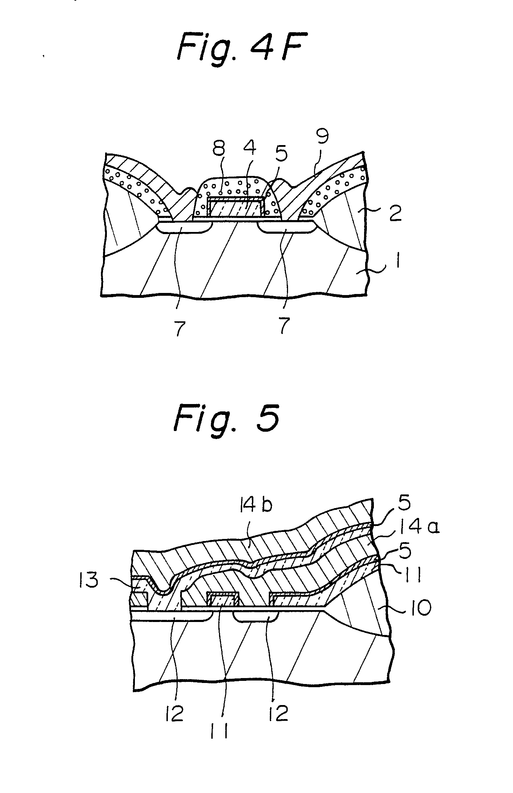

Referring to Fig. 4F, the MOS type transistor is then completed by the following well known process: an impurity of a conductive type different from that of the substrate 1 is ion implanted to form the source and drain region 7. Then, an insulating layer 8 of phosphosilicate glass or the like is formed over the entire surface of the substrate, and contact holes for the source and drain electrodes are formed by etching. Metal such as aluminum is vacuum vapor deposited and patterned to form the interconnection lines 9.

Referring to Fig. 5, the transition metal gate electrodes interconnection lines 11 covered with silicide 5 obtained by the method according to the present invention can be applied to a high packing density RAM. Reference numeral 10 shows an oxide layer, 12 a diffusion layer having a conductive type opposite to the substrate, 13 another layer of high melting point metal gate electrodes and interconnection lines covered with silicide, 14a an insulating layer situated between other layers, and 14b a covering insulating layer composed of, for example, phosphosilicate glass and silicon dioxide.

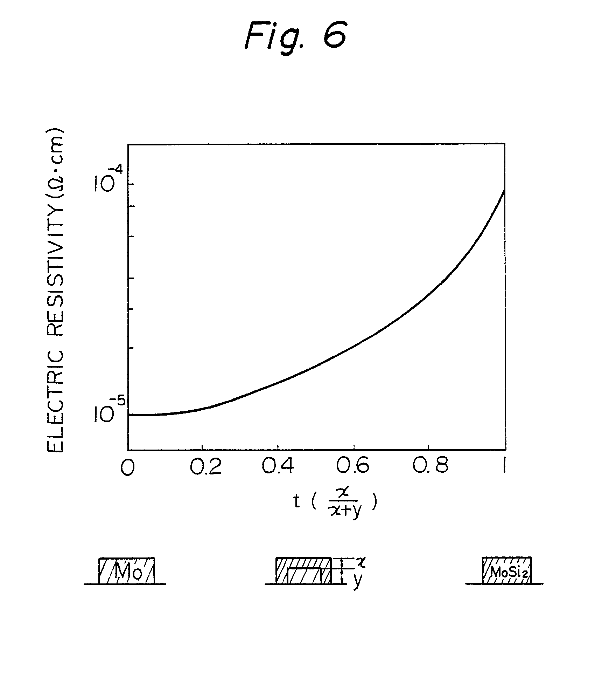

Referring to Fig. 6, the electrical resistivity of the molybdenum-silicide-covered molybdenum gate obtained by the reaction of the molybdenum with the amorphous silicon, according to the present invention, is low. Namely, the electrical resistivity of pure molybdenum and molybdenum silicide is $1 \times 10^{-5}$ $\Omega \cdot cm$ and $1 \times 10^{-4}$ $\Omega \cdot cm$, respectively. Thus, even though the portion having the half thickness of molybdenum is changed to molybdenum silicide, the calculated electrical resistivity is about $2 \times 10^{-4}$, which is substantially close to that of molybdenum.

It is preferable that the thickness of the molybdenum silicide after the silicification be ½ to ⅓ of the initial thickness of the molybdenum, but also that it be not less than 100 nm. Such a silicide has a strong resistance to reagents, particularly acids, and has a low electrical resistivity, as mentioned above.

While the invention has been described and illustrated in connection with composite electrode structures in a semiconductor device in which the patterned gate electrode is constituted of molybdenum, it is apparent from the similarity of compounds of tungsten to compounds of molybdenum, particularly oxides and silicides, that the patterned gate electrode may also be constituted of tungsten. The patterned gate electrodes may also be made of one of high melting point metals including titanium, niobium, tantalum, vanadium, hafnium, zirconium, chromium, or one of noble metals including palladium, platinum or of nickel.

**Claims**

1. A method of producing a semiconductor device wherein a substrate of a semiconductor material (1) is provided and a conductor of a transition metal (4) is formed in a desired pattern on said substrate (1), characterized by: forming a layer of amorphous silicon (6) on said conductor (4), heating said substrate and said layer of amorphous silicon (6) to a temperature enough to react said layer of amorphous silicon with said conductor, thereby an overlying layer of a silicide (5) of said transition metal is formed.

2. A method according to claim 1, wherein said transition metal (4) is selected from the group consisting of high melting point metals and noble metals.

3. A method of claim 2, wherein said high melting point metal is selected from at least one of the group consisting of molybdenum, titanium, niobium, tantalum, tungsten, vanadium, hafnium, zirconium, and chromium.

4. A method according to claim 2, wherein said metal is selected from at least one of the group consisting of nickel, palladium, and platinum.

5. A method according to claim 1 wherein said layer of amorphous silicon (6) is formed by a process of sputter deposition.

6. A method according to claim 1 or 5 wherein said layer of amorphous silicon (6) is formed to a thickness of 50 to 200 nm.

7. A method according to any one of claims 1, 5, and 6 wherein as the pretreatment of said sputtering deposition of the amorphous silicon (6), the surface of the transition metal (4) is inversely sputtered.

8. A method according to any one of claims 1 through 7, wherein prior to the formation of said conductor of transition metal (4), a layer of amorphous silicon (6) is formed on the surface of said substrate of semiconductor material (1).

9. A method according to claim 1 wherein the substrate including the patterned molybdenum conductor (4) and the layer of amorphous silicon (6) is heated to a temperature of 600°C to 1000°C for 30 to 100 minutes.

10. A method according to any preceding claim which includes the step of removing unreacted silicon by selective plasma etching.

**Patentansprüche**

1. Verfahren zur Herstellung einer Halbleitervorrichtung, bei der ein Substrat aus Halbleitermaterial (1) vorgesehen ist, und ein Leiter aus Übergangsmetall (4) in einem gewünschten Muster auf dem genannten Substrat 1 gebildet wird, gekennzeichnet durch: Bildung einer Schicht aus amorphem Silicium (6) auf dem genannten Leiter (4), Erhitzen des genannten Substrats und der genannten Schicht aus amorphem Silicium (6) auf eine Temperatur, die ausreicht, um die genannte Schicht aus amorphem Silicium mit dem genannten Leiter reagieren zu machen, wodurch eine aufliegende Schicht aus Silicid (5) des genannten Übergangsmetalls gebildet wird.

2. Verfahren nach Anspruch 1, bei dem das genannte Übergangsmetall (4) ausgewählt ist aus der Gruppe bestehend aus Metallen mit hohem Schmelzpunkt und Edelmetallen.

3. Verfahren nach Anspruch 2, bei dem das genannte Metall mit hohem Schemlzpunkt ausgewählt ist aus wenigstens einem der Gruppe bestehend aus Molybdän, Titan, Niob, Tantal, Wolfram, Vanadium, Hafnium, Zirkonium und Chrom.

4. Verfahren nach Anspruch 2, bei dem das genannte Metall ausgewählt ist aus wenigstens einem der Gruppe bestehend aus Nickel, Palladium und Platin.

5. Verfahren nach Anspruch 1, bei dem die genannte Schicht aus amorphem Silicium (6) durch ein Zerstäubungsdepositionsverfahren gibildet wird.

6. Verfahren nach Anspruch 1 oder 5, bei dem die Schicht aus amorphem Silicium (6) in einer Dicke von 50 bis 200 nm gebildet wird.

7. Verfahren nach einem der Ansprüche 1, 5 und 6, bei dem als Vorbehandlung der genannten Zerstäubungsdeposition des amorphem Siliciums (6) die Oberfläche des Übergangsmetalls (4) invers zerstäubt wird.

8. Verfahren nach einem der Ansprüche 1 bis 7, bei dem vor der Bildung des genannten Leiters aus Übergangsmetall (4), eine Schicht aus amorphem Silicium (6) auf der Oberfläche des genannten Substrats aus Halbleitermaterial (1) gebildet wird.

9. Verfahren nach Anspruch 1, bei dem das Substrat, einschließlich des gemusterten Molybdänleiters (4) und der Schicht aus amorphem Silicium (6), 30 bis 100 Minuten lang auf eine Temperatur von 600°C bis 1000°C erhitzt wird.

10. Verfahren nach einem der vorhergehenden Ansprüche, welches den Schritt der Entfernung von nicht-reagiertem Silicium durch selektives Plasmaätzen umfaßt.

**Revendications**

1. Procédé pour fabriquer un dispositif à semiconducteur dans lequel un substrat d'un matèriau semiconducteur (1) est prévu et un conducteur d'un métal de transition (4) est formé selon une configuration voulue sur le substrat (1), caractérisé en ce qu'il consiste à: former une couche de silicium amorphe (6) sur le conducteur (4), chauffer le substrat et la couche de silicium amorphe (6) jusqu'à une température suffisante pour faire réagir la couche de silicium amorphe avec le conducteur, une couche d'une siliciure (5) du métal de transition de revétement étant de la sorte formée.

2. Procédé selon la revendication 1, dans lequel le métal de transition (4) est choisi dans le groupe constitué par les métaux à point de fusion élevé et les métaux nobles.

3. Procédé selon la revendication 2, dans lequel le métal à point de fusion élevé est choisi comme étant au moins un élément du groupe constitué par le molybdène, le titane, le biobium, le tantale, le tungstène, le vanadium, l'hafnium, le zirconium, et le chrome.

4. Procédé selon la revendication 2, dans lequel le métal est choisi comme étant au moins un élément du groupe constitué par le nickel, le palladium et le platine.

5. Procédé selon la revendication 1, dans lequel la couche de silicium amorphe (6) est formée par une opération de dépôt par pulvérisation cathodique.

6. Procédé selon l'une quelconque des revendications 1 et 5, dans lequel la couche de silicium amorphe (6) est formée jusqu'à une épaisseur comprise entre 50 et 200 nanomètres.

7. Procédé selon l'une quelconque des revendications 1, 5 et 6, dans lequel comme prétraitement du dépôt par pulvérisation cathodique du silicium amorphe (6), la surface du métal de transition (4) fait l'objet d'une pulvérisation inversée.

8. Procédé selon l'une quelconque des revendications 1 à 7, dans lequel, avant la formation du conducteur de métal de transition (4), on forme une couche de silicium amorphe (6) sur la surface du substrat de matériau semiconducteur (1).

9. Procédé selon la revendication 1, dans lequel le substrat incluant le conducteur de molybdène formé en dessin (4) et la couche de silicium amorphe (6) est chauffée jusqu'à une température comprise entre 600°C et 1000°C pendant une période comprise entre 30 et 100 minutes.

10. Procédé selon l'une quelconque des revendications 1 à 9, consistant à retirer le silicium n'ayant pas réagi par attaque sélective par plasma.

## Fig. 1

## Fig. 2

## Fig. 3

## Fig. 4 A

## Fig. 4 B

## Fig. 4 C

## Fig. 4 D

## Fig. 4 d

## Fig. 4 E

## Fig. 4 F

## Fig. 5

## Fig. 6